Europäisches Patentamt

European Patent Office

Office européen des brevets

(11) Veröffentlichungsnummer: **0 271 718 B1**

(12) **EUROPÄISCHE PATENTSCHRIFT**

(45) Veröffentlichungstag der Patentschrift: **04.03.92**

(21) Anmeldenummer: **87116739.1**

(22) Anmeldetag: **12.11.87**

(51) Int. Cl.⁵: **G11C 11/409**, G11C 7/00

(54) **Digitalverstärkeranordnung in integrierten Schaltungen.**

(30) Priorität: **18.11.86 DE 3639347**

(43) Veröffentlichungstag der Anmeldung:
**22.06.88 Patentblatt 88/25**

(45) Bekanntmachung des Hinweises auf die
Patenterteilung:
**04.03.92 Patentblatt 92/10**

(84) Benannte Vertragsstaaten:
**AT DE FR GB IT NL**

(56) Entgegenhaltungen:
**EP-A- 0 011 448**
**EP-A- 0 185 572**

**PATENT ABSTRACTS OF JAPAN, Band 7, Nr.**
**238 (P-231)[1383], 22.Oktober 1983; & JP-A-58**
**125 293 (HITACHI SEISAKUSHO K.K.)**
**26-07-1983**

**ELECTRONICS, 14 Juni 1984, MOHSEN et**
**al.:"C-MOS 256-K RAM with wideband output**
**stands by on microwatts", S.138- 143**

(73) Patentinhaber: **SIEMENS AKTIENGESELL-**
**SCHAFT**
**Wittelsbacherplatz 2**
**W-8000 München 2(DE)**

(72) Erfinder: **Kraus, Rainer, Dipl.-Phys.**
**Weidener Strasse 21**
**W-8000 München 83(DE)**
Erfinder: **Kowarik, Oskar, Dr.**
**Goethering 70**
**W-8018 Grafing(DE)**
Erfinder: **Paul, Manfred, Dipl.-Ing.**
**Fichtenstrasse 18**
**W-8043 Unterföhring(DE)**

## Beschreibung

Integrierte Schaltung mit einer Digitalverstärkeranordnung

Die Erfindung betrifft eine integrierte Schaltung mit einer Digitalverstärkeranordnung zum Verstärken einer Spannungsänderung in der integrierten Schaltung, insbesondere in Halbleiterspeichern.

Zum Speichern von Information in Halbleiterspeichern wird heute fast ausschließlich das Konzept der Ein-Transistor-Zelle verwendet, da diese Schaltung die Zahl der Elemente zur Speicherung eines Informationsbits auf ein Minimum reduziert. Die Ein-Transistor-Zelle besteht dabei aus einem Speicherkondensator und einem Auswahltransistor, der über eine Wortleitung gesteuert, die auf dem Kondensator gespeicherte elektrische Ladung an eine Bitleitung überträgt bzw. von dieser abtrennt. Zum Auslesen der Information wird die Bitleitung zunächst auf eine Referenzspannung, meist 2,5 V, vorgespannt und dann von der Spannungsquelle abgetrennt. Durch Offnen des Auswahltranisistors kommt es zum Ladungsausgleich zwischen Speicherkondensator und Bitleitung. Dabei wird eine Spannungsänderung in der Bitleitung initiiert, die durch einen Bewerter verstärkt und an den Ausgang des Speichers geführt wird. Das Auslesen der Information erfolgt bei der Ein-Transistor-Zelle zerstörend, d.h. nach jedem Lesevorgang muß die Information wieder neu eingeschrieben werden.

Seit der Einführung des Ein-Transistor-Zellen-Konzeptes sind mehrere Bewerter-Bauarten vorgeschlagen worden. Bei nahezu allen dynamischen Speichern wird heute jedoch das symmetrische Flip-Flop als Bewerter und Verstärker eingesetzt, das die Spannungsänderung auf der Bitleitung gegenüber einer zweiten, identischen Referenz-Bitleitung vergleicht. Diese Referenz-Bitleitung enthält die gleiche Anzahl Ein-Transistor-Zellen und ist entweder parallel zur Bitleitung oder symmetrisch zum Bewerter angeordnet. Bitleitung und Referenz-Bitleitung bilden dabei zusammen ein Bitleitungspaar, dessen Spannungsänderungen vom Bewerter digitalisiert werden.

Die Spannungsänderungen auf den Bitleitungen sind abhängig vom Verhältnis der Kapazität der Bitleitung zur Kapazität einer einzelnen Speicherzelle. Damit der Bewerter die Spannungsänderung von störenden Fehlsignalen eindeutig unterscheiden kann, darf die Bitleitungs-Kapazität in der Regel die 10-fache Kapazität einer Speicherzelle nicht übersteigen. Dies hat zur Folge, daß pro Bitleitung nur eine begrenzte Anzahl von Ein-Transistor-Zellen angeschlossen werden kann. Damit steigt zwangsläufig bei einer Erhöhung der Speicherkapazität auch die Anzahl der Bewerter proportional zur Zahl der Ein-Transistor-Zellen.

Aus "Electronics", 14. Juni 1984, Seiten 138 bis 143, ist eine integrierte Schaltung, nämlich eine Halbleiterspeicherschaltung, mit einer Digitalverstärkeranordnung bekannt. Dabei ist ein Digitalverstärker zwischen zwei Bitleitungspaaren angeordnet. Das eine Bitleitungspaar ist an seinem dem Digitalverstärker abgewandten Ende an einen üblichen Dateneingangs-/Datenausgangsbus angeschlossen, wobei für die im Lesebetrieb ausgelesenen Daten vor ihrer Ubergabe an den Dateneingangs-/Datenausgangsbus keine weitere Verstärkung vorgesehen ist. Eine solche erfolgt dann erst im Bereich zwischen Dateneingangs-/Datenausgangsbus und Ausgangspuffern. Beide Bitleitungspaare weisen allerdings jeweils eine Flip-Flop-Schaltung aus kreuzgekoppelten Transistoren auf zur Wiederherstellung der durch Auslesen aus Speicherzellen in diesen zerstörten Information (Zurückschreiben, "Active Restore"). Dieser Vorgang ist dann auf das jeweilige Bitleitungspaar beschränkt. Das andere Bitleitungspaar kann als Verlängerungspaar bezüglich des einen Bitleitungspaares angesehen werden.

Weiterhin ist an jedem internen Digitalverstärkerknoten ein Paar von Kapazitäten angeschlossen. Die Verbindungen zwischen dem Digitalverstärker und den beiden Bitleitungspaaren erfolgt über zwei Paare von Transfertransistoren, die im Multiplexbetrieb, d.h. alternativ zueinander, betrieben werden.

Aus der EP-A 0 011 448 ist ebenfalls eine integrierte Schaltung, wiederum eine Halbleiterspeicherschaltung, mit einer Digitalverstärkeranordnung bekannt. Diese ist sowohl im Verlauf von (längeren) Wortleitungen wie auch im Verlauf von Bitleitungen einsetzbar. Im letzteren Fall wird die Aufgabe gelöst, eine aufgrund des chemischen Aufbaus (polykristalline Halbleiterschicht) oder des verwendeten Herstellungsprozesses (Diffusionsbahnen im Substrat) verschlechterte Zugriffszeit (wegen erhöhtem Widerstand der Bitleitungen) wenigstens teilweise zu kompensieren.

Die EP-A 0 185 572 offenbart eine integrierte (Speicher-) Schaltung, bei der Bitleitungspaare in mehrere Abschnitte mit Speicherzellen eingeteilt sind. Jeder Abschnitt eines Bitleitungspaares weist, vom Datenbus aus in Richtung Ende des Bitleitungspaares betrachtet, ein Paar von Schaltern, anschließend daran eine Bewerterschaltung (sense amplifier) sowie, wiederum daran anschließend, eine Speicherzellenanordnung auf.

Aufgabe der vorliegenden Erfindung ist es, die in Halbleiterspeichern für die Speicherung von Information notwendige Chipfläche zu reduzieren.

Zur Lösung dieser Aufgabe sieht die Erfindung gemäß dem Patentanspruch 1 vor, Bitleitungspaare über ihre zulässige Kapazität hinaus zu verlängern und die Verlängerungen über Digitalverstärker an die Bitleitungspaare anzukoppeln.

Durch den Einbau eines Digitalverstärkers je Bitleitungspaar kann an jeden Bewerter die doppelte Anzahl von Ein-Transistor-Zellen angeschlossen werden. Dies kann vorteilhafterweise entweder dazu genutzt werden, bei gleichbleibender Bewerterzahl die Speicherkapazität zu verdoppeln oder aber bei gleichbleibender Speicherkapazität die Zahl der notwendigen Bewerter zu halbieren. Da der Flächenbedarf eines Digitalverstärkers kleiner ist als der eines Bewerters, führt dies in beiden Fällen zu einer Flächenverringerung.

Ein weiterer Vorteil ergibt sich, wenn durch den Einbau eines Digitalverstärkers die Zahl der Speicherzellen pro Bitleitungspaar bzw. pro Verlängerung unter die bezüglich des Kapazitätsverhältnisses maximal zulässige Zahl gesenkt wird. Da durch eine Verkürzung der Bitleitung auch deren Kapazität reduziert wird, ist die beim Auslesen einer Speicherzelle im Bitleitungspaar hervorgerufene Spannungsänderung höher. Dieser Effekt läßt sich entweder dazu nutzen, die Kapazität und damit die Fläche jeder einzelnen Speicherzelle zu reduzieren oder aber die Störsicherheit der Halbleiterschaltung zu erhöhen.

In den Unteransprüchen sind weitere vorteilhafte Schaltungsanordnungen dieses Digitalverstärkers angegeben.

Anhand der Zeichnung werden Ausführungsbeispiele des Erfindungsgegenstandes näher erläutert. Hierzu zeigt:

FIG 1 eine Schaltungsanordnung nach der Erfindung mit einem Digitalverstärker, einem Bitleitungspaar, einer Verlängerung und einem Bewerter,

FIG 2 den Digitalverstärker nach FIG 1 in einer erweiterten Transistorschaltung zum Rückschreiben der ausgelesenen Information.

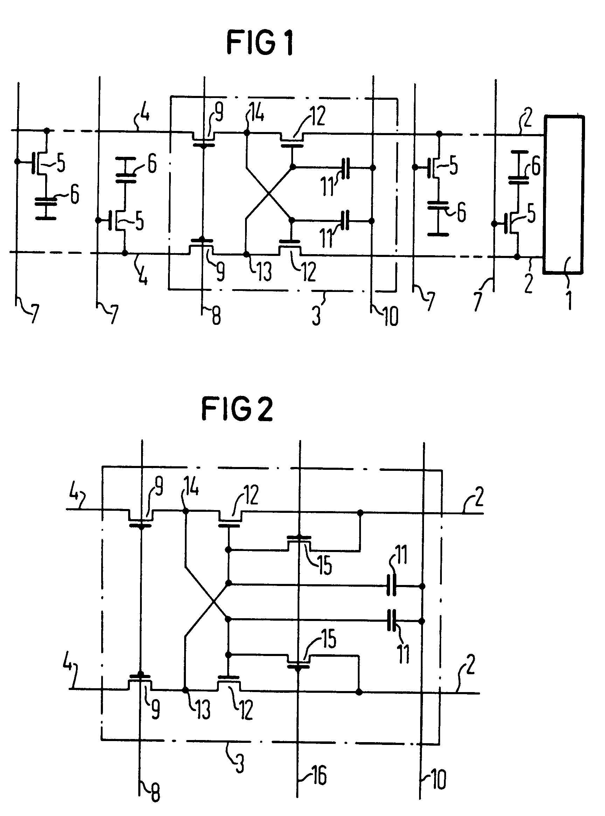

FIG 1 zeigt einen Bewerter 1 mit einem Bitleitungspaar 2, 2, das Verlängerungen 4, 4 aufweist, die über einen Digitalverstärker 3 mit dem Bitleitungspaar 2, 2 verbunden sind. An dem Bitleitungspaar 2, 2 und den Verlängerungen 4, 4 sind Ein-Transistor-Zellen mit je einem Auswahltransistor 5 und einem Speicherkondensator 6 angeschlossen. Die Auswahltransistoren 5 sind dabei gateseitig mit separaten Wortleitungen 7 verbunden. In den Digitalverstärker 3 führen eine Taktleitung 8 zu zwei Trenntransistoren 9, 9 und über Koppelkondensatoren 11, 11 eine Impulsleitung 10 an zwei kreuzgekoppelte Transistoren 12, 12, deren Gateanschlüsse an Knoten 13 und 14 liegen.

Im Grundzustand sind die Verlängerungen 4, 4 vom Bitleitungspaar 2, 2 durch die geöffneten Transistoren 12, 12 getrennt. Ein Auslesen der Daten aus den Speicherkondensatoren, welche an das Bitleitungspaar 2, 2 gekoppelt sind, verläuft somit unbeeinflußt vom Digitalverstärker 3 bzw. der Verlängerung 4, 4 in bekannter Weise, indem die Spannungsänderung im Bitleitungspaar 2, 2 vom Bewerter 1 bewertet, verstärkt und weitergeleitet wird.

Wird hingegen eine in den Verlängerungen 4, 4 liegende Ein-Transistor-Zelle ausgelesen, so entsteht zunächst zwischen den Knoten 13 und 14 eine Spannungsdifferenz, die auch nach einer Abtrennung der Verlängerung 4, 4 durch Öffnen der Trenntransistoren 9, 9 erhalten bleibt. Durch einen Impuls auf die beiden Koppelkondensatoren 11, 11 werden die beiden Knoten 13 und 14 hochgezogen, bis von den beiden kreuzgekoppelten Transistoren 12, 12 derjenige mit der höheren Gatespannung zu leiten beginnt. Dadurch fließt dessen Ladung auf die entsprechende Bitleitung ab und bewirkt dort eine Spannungsänderung, die vom Bewerter in der üblichen Weise gelesen wird. Die vom Digitalverstärker abgegebene Spannungsänderung ist damit größer als die Spannungsdifferenz zwischen den Knoten 13 und 14. Die tatsächliche Höhe des Ausgangssignals wird bestimmt durch die Größe des Signals auf der Impulsleitung 10 und durch das Verhältnis zwischen den Koppelkapazitäten 11, 11 und den Kapazitäten der Bitleitungen 2, 2 und ist somit unabhängig von der Größe des Eingangssignals.

In FIG 2 ist der Digitalverstärker 3 nach FIG 1 um zwei Rückschreib-Transistoren 15, 15, die von einer Rückschreib-Taktleitung 16 gesteuert werden, erweitert.

Zum Rückschreiben der beim Auslesen zerstörten Information der in den Verlängerungen 4, 4 liegenden Speicherkondensatoren werden die Rückschreibtransistoren 15, 15 durch einen Impuls aus der Rückschreibtaktleitung 16 geöffnet. Das vom Bewerter ausgehende Rückschreibsignal kann dadurch über das Bitleitungspaar 2, 2 in die Verlängerung 4, 4 zurückgeschrieben werden.

**Patentansprüche**

1. Integrierte Schaltung mit einer Digitalverstärkeranordnung zum Verstärken von Potentialdifferenzen mit folgenden Merkmalen:
   - Ein Bitleitungspaar (2,2) und ein Verlängerungspaar (4,4) sind über einen Digitalverstärker (3) aneinander ankoppelbar,
   - der Digitalverstärker (3) enthält mit dem Verlängerungspaar (4,4) verbundene taktgesteuerte Trenntransistoren (9,9) und ein kreuzgekoppeltes Transistorpaar (12,12),
   - das kreuzgekoppelte Transistorpaar (12,12) verstärkt am Verlängerungspaar (4,4) auftretende Potentialdifferenzen,
   - der Digitalverstärker (3) enthält weiterhin Kapazitäten (11, 11), die einerseits mit den Gates der Transistoren des kreuzgekoppelten Transistorpaares (12,12) und andererseits mit einer Impulsleitung (10) verbunden sind,

**gekennzeichnet durch** folgende Merkmale:

- Der Digitalverstärker (3) enthält lediglich ein Paar der Kapazitäten (11,11),
- er enthält lediglich ein Paar der Trenntransistoren (9,9),
- die Trenntransistoren (9,9) sind mit ihren Source-/Drain-Strecken in Serie zu den Source-/Drain-Strecken der Transistoren des kreuzgekoppelten Transistorpaares (12,12) angeordnet,
- das kreuzgekoppelte Transistorpaar (12,12) dient weiterhin einem Übertragen der verstärkten Potentialdifferenz über seine Source-/Drain-Strecken an einen am Ende des zugehörigen Bitleitungspaares (2,2) angeordneten Bewerter (1).

2. Integrierte Schaltung nach Anspruch 1, **da-durch gekennzeichnet,** daß der Digitalver-stärker (3) eine Transistoranordnung (15,15) enthält zum Rückschreiben der über ein Ver-längerungspaar (4,4) ausgelesenen, verstärk-ten Information in das Verlängerungspaar (4,4).

**Claims**

1. Integrated circuit with a digital amplifier arrangement for the amplification of potential differences, having the following features:

- one bit line pair (2, 2) and one extension pair (4, 4) can be coupled to one another via a digital amplifier (3),
- the digital amplifier (3) contains clock-controlled isolation transistors (9, 9) connected to the extension pair (4, 4) and a cross-coupled transistor pair (12, 12),
- the cross-coupled transistor pair (12, 12) amplifies potential differences occurring at the extension pair (4, 4),
- the digital amplifier (3) furthermore contains capacitors (11, 11) which are connected on the one hand to the gates of the transistors of the cross-coupled transistor pair (12, 12) and on the other hand to a pulse line (10),

characterised by the following features:

- the digital amplifier (3) contains only one pair of the capacitors (11, 11),
- it contains only one pair of the isolation transistors (9, 9),
- the isolation transistors (9, 9) are arranged with their source/drain paths in series with the source/drain paths of the transistors of the cross-coupled transistor pair (12, 12),

- the cross-coupled transistor pair (12, 12) serves furthermore for a transmission of the amplified potential difference via its source/drain paths to an evaluator (1) arranged at the end of the associated bit line pair (2, 2).

2. Integrated circuit according to Claim 1, characterised in that the digital amplifier (3) contains a transistor arrangement (15, 15) for writing back the amplified information, which was read out via an extension pair (4, 4), into the extension pair (4, 4).

**Revendications**

1. Circuit intégré comportant un dispositif amplificateur numérique servant à amplifier des différences de potentiel, présentant les caractéristiques suivantes :

- un couple (2,2) de lignes de transmission de bits et un couple de prolongements (4,4) peuvent être accouplés entre eux par l'intermédiaire d'un amplificateur numérique (3),
- l'amplificateur numérique (3) comporte des transistors de séparation (9,9) commandés de façon cadencée et raccordés au couple de prolongements (4,4), et un couple de transistors (12,12) couplés selon un couplage croisé,
- le couple de transistors (12,12) couplés selon un couplage croisé amplifie des différences de potentiel apparaissant dans le couple de prolongements (4,4),
- l'amplificateur numérique (3) comporte en outre des capacités (11,11), qui sont raccordées d'une part aux grilles des transistors du couple de transistors (12,12) couplés selon un couplage croisé et d'autre part à une ligne de transmission d'impulsions (10),

caractérisé par les particularités suivantes :

- l'amplificateur numérique (3) comporte uniquement un couple de capacités (11,11),
- il comporte uniquement un couple de transistors de séparation (9,9),
- les transistors de séparation (9,9) ont leurs voies source/drain branchées en série avec les voies source/drain des transistors du couple de transistors (12,12) couplés selon un couplage croisé,
- le couple de transistors (12,12) couplés selon un couplage croisé est utilisé en outre pour transmettre la différence de potentiel amplifiée par l'intermédiaire d'une voie source/drain à un dispositif d'évaluation (1) disposé à l'extrémité du couple associé de lignes de transmission de bits (2,2).

2. Circuit intégré suivant la revendication 1, caractérisé par le fait que l'amplificateur numérique (3) comporte un dispositif à transistors (15,15) servant à enregistrer en retour l'information amplifiée, qui est lue par l'intermédiaire d'un couple de prolongements (4,4), dans ce couple.

EP 0 271 718 B1

# FIG 1

# FIG 2

6